# EUROPEAN PATENT SPECIFICATION

(11) **EP 0 214 621 B1**
(45) Date of publication and mention of the grant of the patent: **31.03.1993**
(21) Application number: 86112244.8
(22) Date of filing: 04.09.1986
(51) Int. Cl.: H01L 23/04, H01L 23/28, H01L 23/18

(54) **A package comprising a substrate and at least one electronic component**
Packung mit einem Substrat und mindestens einem elektronischen Bauelement
Empaquetage comprenant un substrat et au moins un composant électronique

(30) Priority: 05.09.1985 JP 197007/85; 06.12.1985 JP 273368/85; 06.12.1985 JP 273369/85
(43) Date of publication of application: 18.03.1987
(73) Proprietor: NEC CORPORATION, Tokyo (JP)
(72) Inventor: Yamaguti, Yukio c/o NEC Corp., Minato-ku Tokyo (JP)
(74) Representative: Glawe, Delfs, Moll & Partner

(56) References cited:
- EP-A- 0 103 067
- EP-A- 0 117 211
- US-A- 4 326 238
- PATENT ABSTRACTS OF JAPAN, vol. 9, no. 181 (E-331)[1904], July 26, 1985; & JP-A-60 53 061 (HITACHI MAIKURO COMPUTER ENG. K.K.) 26-03-1985
- PATENT ABSTRACTS OF JAPAN, vol. 4, no. 189 (E-39)[671], December 25, 1980; & JP-A-55 130 152 (HITACHI SEISAKUSHO K.K.) 08-10-1980
- PATENT ABSTRACTS OF JAPAN, vol. 9, no. 126 (E-318)[1849], May 31, 1985; & JP-A-60 12 745 (MATSUSHITA DENKO K.K.) 23-01-1985

## Description

### BACKGROUND OF THE INVENTION

The present invention relates to a package with electronic components mounted to be easily removed without damage.

In a conventional package, integrated circuit (IC) chips are mounted on a substrate on and in which wirings are formed to be electrically connected to circuits contained in the chips by leads. Further, the leads and the upper surface of the substrate are coated with silicone resin. This resin coating is intended to protect said wirings formed on the substrate and said leads from moisture. An example of such a conventional package is disclosed in a paper entitled "Non-hermetic packaging techniques for hybrids" by Brad Older and Richard A. Bly, published in June 1979 in the Electronic Packaging and Production, pp. 137 to 139.

In the disclosed prior art package, it is difficult, when replacing the chips, to remove the silicone resin existing in each space surrounded by the leads, the lower surface of each chip and the upper surface of the substrate. Moreover, when the package is soaked in organic solvent to remove the silicone resin, the resin expands so that the leads may be cut or come off the substrate.

US-A-4 326 238 discloses an electronic circuit package in which an electronic circuit element together with connecting beam leads is embedded in resin layers. The resin layers are cured by air oxidation which starts from the surface of the resin, thereby enabling, for a certain period of time, the easy replacement of the electronic element (e.g. after product testing).

### SUMMARY OF THE INVENTION

One object of the invention is, therefore, to provide a package free from the above-mentioned disadvantages in the conventional package.

According to an aspect of the invention, there is provided a package which comprises: a substrate; a plurality of pads formed on the upper surface of said substrate; at least one electronic component having a plurality of leads to be connected to said pads and mounted on the upper surface of said substrate; a fluid silicone material provided on the upper surface of said substrate to fill the space beneath said leads and the lower surface of said electronic component or even to completely embed said leads; and a gel-state silicone material which covers the fluid silicone material and the remaining upper surface, if any of said substrate.

### BRIEF DESCRIPTION OF THE DRAWINGS

Other features and advantages of the invention will become more apparent from the following detailed description when taken in conjunction with the accompanying drawings in which:
FIG. 1 and FIG. 2 show a cross-sectional view and a plan view of a first embodiment, respectively; and
FIG. 3 shows a cross-sectional view of a second embodiment.

In the drawings, the same reference numerals represent the same structural elements.

### DETAILED DESCRIPTION OF THE PREFERRED EMBODIMENTS

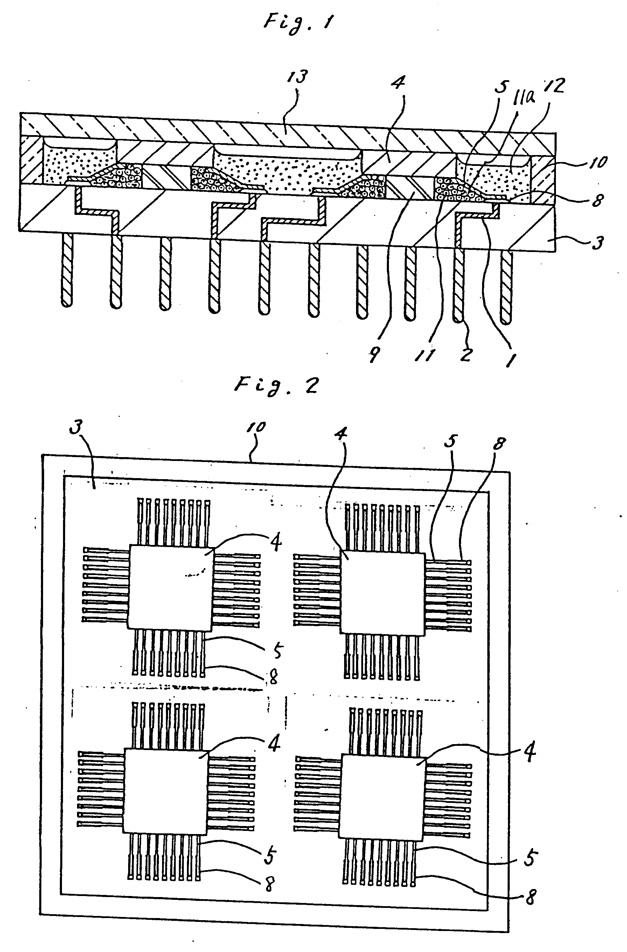

Referring to FIG. 1, a first embodiment of the invention comprises a substrate 3 including a plurality of conductive wirings 1; a plurality of input/output pins 2 provided on the lower surface of the substrate 3; a plurality of pads 8 provided on the upper surface of the substrate 3; a frame 10 made of iron-nickel-cobalt alloy and fitted onto the circumference of the upper surface of the substrate 3 with an adhesive (for instance, an epoxy adhesive); a cap 13 made of aluminum nitride and so fitted to the frame 10 with an adhesive as to be opposite to the upper surface of the substrate 3; a plurality of spacers 9 made of silicone rubber and fixed to the upper surface of the substrate 3 with an adhesive; a plurality of integrated circuit (IC) chips 4 fixed to the spacers 9 with an adhesive; and first silicone-filled portions 11 and a second silicone-filled portion 12 formed by a method, which will be described later on. Onto the upper surface of the cap 13 may be fitted one or more heat sinks for air-cooling or water-cooling. Between the lower surface of the cap 13 and the upper surfaces of the chips 4 may be inserted a compound having a good heat-conductivity. Heat generating from the chips 4 is transmitted either directly or through the compound to the cap 13, and further dispersed outside through the heat sink. If the frame 10 is formed of an electrically insulating material, an electro-conductive adhesive can be used.

Around the lower surface of each of the chips 4 are fitted one ends of a plurality of leads 5 at minute intervals. The other ends of the leads 5, radially extending from the chips 4, are connected to the pads 8 by bonding. As a result, the pins 2 and circuits contained within the chips 4 are electrically connected through the wirings 1, the pads 8 and the leads 5.

Next will be described how the silicone-fitted portions 11 and 12 are to be formed.

First, after the mounting of the chips 4 onto the substrate 3, a first fluid silicone material having a high viscousness is filled by using an injector into spaces 11a, which are formed below the chips 4. Each of the spaces 11a is surrounded by the lower surface of the corresponding one of the chips 4, the corresponding ones of the leads 5, four sides of the corresponding one of the spacers 9 and the upper surface of the substrate 3. As a result, the first silicone-filled portions 11 are formed. As this first silicone material, for instance, silicone impregnant available from Shinetsu Silicone Company under the trade name KJF-812 may be used. Next is poured a second fluid silicone material over the substrate 3 to form the second silicone-fitted portion 12. As the second silicone material, for instance, heat-hardened type potting agent available from Toray Silicone Company, Ltd. under the trade name SH1851 may be used. Since the first silicone material has a higher viscousness than the second silicone material, the former remains within the spaces 11a not to mix with the latter. After that, the entire package is kept for an hour or two in an air atmosphere at about 125°C (degrees centigrade) to harden the second silicone material into a gel state. At this time, the first silicone material does not become hard. The portions 11 and 12 thus formed protect wirings formed on the upper surface of the substrate 3 from moisture and other undesirable factors.

Though the first silicone material used in the embodiment has a high viscousness, other fluid silicone materials having a lower viscousness may be used as well. In that case, the substrate 3 is turned upside down after pouring such a fluid silicone material over the substrate 3. As a result, though the most part of the poured fluid silicone material is discarded, the fluid silicone material within the spaces 11a remains as it stands due to its surface tension. After that, the second silicone material is poured and it alone is hardened by heating.

Further, an ultraviolet (UV) hardened type silicone material can be used for both the portions 11 and 12. In this case, the UV-hardened type silicone material is poured over the substrate 3. An UV ray is then irradiated from above, so that the part of the poured silicone material hidden by the chips 4 and the leads 5 when the substrate 3 is viewed from above, is unhardened to constitute the portions 11 while the remaining part is hardened into a gel state to form the portion 12. As such an UV-hardened type silicone material, the one available from Toshiba Silicone Company under the trade name TUV6000 may be used.

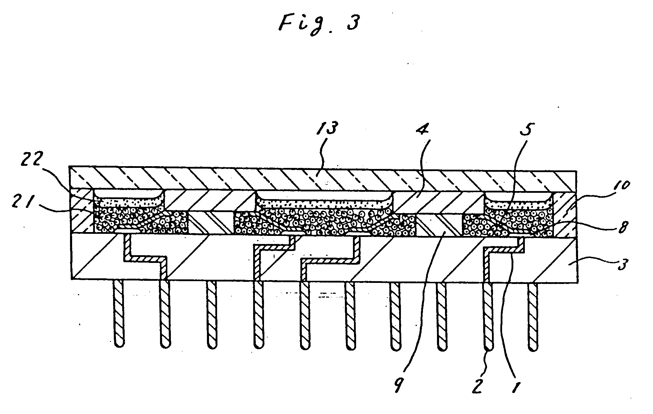

Referring now to FIG. 3, like the first embodiment, in a second embodiment of the invention, the chips 4 and the frame 10 are first mounted over the substrate 3. Next, a third silicone material is poured to form silicone-filled portions 21 of sufficient height to have the leads 5 embedded therein, followed by the pouring of a fourth silicone material for the forming of a fourth silicone-filled portion 22. As the third and fourth silicone materials, the above-mentioned KJF-812 and SH1851 may be employed, respectively. Like in the case of the first embodiment, the entire package is then kept for an hour or two in an air atmosphere at about 125°C to harden the fourth silicone material alone into a gel state. Finally, the cap 13 is fitted to the frame 10 to complete the package.

Though the heat-hardened type silicone material is used for the fourth silicone material in the embodiment, an UV-hardened type one, like TUV6000 mentioned above, may be used as well. In this case, naturally the fourth silicone material is hardened by UV irradiation.

When the first through fourth silicone materials of the packages assembled as described above according to the invention are to be removed from the portions 11, 12, 21 and 22 to replace the chips or for any other purpose in changing the design of or repairing the package, the first or third silicone material can be readily washed away from the portion 11 or 21 with organic solvent after removing the second or fourth silicone material from the portion 12 or 22. Therefore, in neither the first nor the second embodiment, the leads 5 will be cut or come off the pads 8 in the process of the silicone removal.

## Claims

1. A package comprising :
A substrate (3);
a plurality of pads (8) formed on the upper surface of said substrate (3);
at least one electronic component (4) having a plurality of leads (5) to be connected to said pads (8) and mounted on the upper surface of said substrate (3);
a fluid silicone material (11) which fills the space surrounded by said leads, the lower surface of said electronic component and the upper surface of said substrate; and
a gel-state silicone material (12) which covers the upper surface of said substrate and the fluid silicone material.

2. A package according claim 1, **characterized** in that the silicon material (12) for covering the upper surface of said substrate and said fluid silicone material (11) is an ultraviolet-gelatinated type silicone material.

3. A package according claim 1, **characterized** in that the silicone material (12) for covering the upper surface of said substrate and said fluid silicone material is a heat-gelatinated type silicone material.

4. A package according anyone of the claims 1-3, **characterized** in that the package further comprising a frame-like member (10) provided on the circumference of the upper surface (3) of the substrate; whereas the fluid silicone material (21) is filled in a space surrounded by the upper surface of said substrate (3) and the inner surfaces of said frame-like member (10) at least to such an extent, that said leads (5) are embedded therein; and
said gel-state silicone material (22) is covering said fluid silicone material (21).

5. A package according claim 4, **characterized** in that a cap (13) is so fitted to said frame-like member (10) as to cover said substrate (3).

## Patentansprüche

1. Packung mit:
einem Substrat (3);
einer Vielzahl von Anschlußflächen (8), die auf der oberen Oberfläche des Substrats (3) ausgebildet sind;
mindestens einer elektrischen Komponente (4) mit einer Vielzahl von Anschlüssen (5), die mit den Anschlußflächen (8) verbunden werden sollen und auf der oberen Oberfläche des Substrats (3) befestigt sind;
einem Fluid-Silikon-Material (11), welches den Zwischenraum ausfüllt, welcher von den Anschlüssen, der unteren Oberfläche der elektronischen Komponente und der oberen Oberfläche des Substrats umgeben wird; und
einem gelförmigen Silikonmaterial (12), welches die obere Oberfläche des Substrats und das Fluidsilikonmaterial bedeckt.

2. Packung nach Anspruch 1,
dadurch **gekennzeichnet,** daß das Silikonmaterial (12) zum Bedecken der oberen Fläche des Substrats und des Fluidsilikonmaterials (11) ein ultraviolett-gelatinierendes Silikonmaterial ist.

3. Packung nach Anspruch 1,
dadurch **gekennzeichnet,** daß das Silikonmaterial (12) zum Bedecken der oberen Fläche des Substrats und des Fluidsilikonmaterials ein hitzegelatinierendes Silikonmaterial ist.

4. Packung nach einem der Ansprüche 1 bis 3,
dadurch **gekennzeichnet,** daß die Packung ferner aufweist ein rahmenförmiges Teil (10), welches auf dem Umfang der oberen Fläche (3) des Substrats vorgesehen ist; wobei das Fluidsilikonmaterial (21) in einen Zwischenraum, der von der oberen Fläche des Substrats (3) und der Innenoberfläche des rahmenförmigen Teiles (10) umgeben ist, zumindest in einem solchen Maße eingefüllt ist, daß die Leitungen (5) darin eingebettet sind; und daß gelförmiges Silikonmaterial (22) das Fluidsilikonmaterial (21) bedeckt.

5. Packung nach Anspruch 4,
dadurch **gekennzeichnet,** daß eine Abdeckung (13) so auf das rahmenförmige Teil (10) eingepaßt ist, daß sie das Substrat 3 überdeckt.

## Revendications

1. Boîtier comprenant :
un substrat (3) ;
une multitude de plots (8) formés sur la surface supérieure du substrat (3) ;
au moins un composant électronique (4) ayant une multitude de broches (5) qui doivent être connectées aux plots (8) et monté sur la surface supérieure du substrat (3) ;
un matériau de silicone fluide (11) qui remplit l'espace défini par les sorties, la surface inférieure du composant électronique et la surface supérieure du substrat, et
un matériau de silicone à l'état de gel (12) qui recouvre la surface supérieure du substrat et le matériau de silicone fluide.

2. Boîtier selon la revendication 1, caractérisé en ce que le matériau de silicone (12) pour recouvrir la surface supérieure du substrat et le matériau de silicone fluide (11) est un matériau de silicone durci aux ultraviolets.

3. Boîtier selon la revendication 1, caractérisé en ce que le matériau de silicone (12) pour recouvrir la surface supérieure du substrat et le matériau de silicone fluide est un matériau de silicone du type à durcissement par la chaleur.

4. Boîtier selon l'une quelconque des revendications 1 à 3, caractérisé en ce que le boîtier comprenant de plus un élément de type cadre (10) prévu sur la circonférence de la surface supérieure (3) du substrat ; tandis que le matériau de silicone fluide (21) est versé dans un espace défini par la surface supérieure du substrat (3) et les surfaces inférieures de l'élément de type cadre (10) au moins dans une mesure où les broches (5) sont enrobées dans celui-ci, et
le matériau de silicone à l'état de gel (22) recouvre le matériau de silicone fluide (21).

5. Boîtier selon la revendication 4, caractérisé en ce que le couvercle (13) est adapté à l'élément de type cadre (10) de façon à recouvrir le substrat (3).
